# EUROPÄISCHE PATENTSCHRIFT

(11) **EP 0 879 550 B1**
(45) Veröffentlichungstag und Bekanntmachung des Hinweises auf die Patenterteilung: **20.10.1999**
(21) Anmeldenummer: 97914131.4
(22) Anmeldetag: 06.02.1997
(51) Int. Cl.: H05H 13/04

(54) **BESTÜCKAUTOMAT MIT PNEUMATISCHER VENTILSTEUERUNG**
MOUNTING MACHINE WITH PNEUMATIC VALVE CONTROL
AUTOMATE POUR DISPOSER DES COMPOSANTS AVEC COMMANDE PNEUMATIQUE A SOUPAPES

(30) Priorität: 08.02.1996 DE 19604603
(43) Veröffentlichungstag der Anmeldung: 25.11.1998
(73) Patentinhaber: SIEMENS AKTIENGESELLSCHAFT, 80333 München (DE)
(72) Erfinder: DÜBEL, Rainer, D-85598 Baldham (DE); MELF, Johann, D-82541 Münsing (DE)
(86) Internationale Anmeldenummer: DE9700241
(87) Internationale Veröffentlichungsnummer: WO9729620

(56) Entgegenhaltungen:
- DE-U- 9 407 004
- US-A- 5 457 874

## Beschreibung

Die Erfindung bezieht sich auf einen Bestückautomaten mit einem Revolverkopf und einer pneumatische Ventilsteuerung für am Revolverkopf angeordnete Saugpipetten zum Aufsetzen von elektrischen Bauelementen auf eine Leiterplatte mit drehbar gelagerten Ventilen und zumindest einer ortsfesten Antriebseinrichtung zum Betätigen jeweils eines Schiebers des Ventils.

Bei Bestückautomaten für elektrischen Bauelemente ist es üblich, sternförmig verteilte Saugpipetten für die Bauelemente an einem rotierbaren Revolverkopf anzuordnen. In einer Aufsetzstellung jeweils einer Saugpipette wird das Vakuum mittels des Steuerventils unterbrochen, so daß das auf die Leiterplatte aufgesetzte Bauelement freigegeben wird. Ein nachfolgender Druckluftstoß bewirkt das sichere Loslösen des Bauelements von der Saugpipette. Mit dem Ventilgehäuse ist ein Kurbeltrieb verbunden, bei dem ein Kurbelzapfen in eine Ringnut des Schiebers eingreift. Der Kurbeltrieb ist zwischen zwei Stellungen verdrehbar und verstellt dabei den Schieber zwischen zwei Schaltstellungen. An einem ortsfesten Teil des Revolverkopfes ist ein als Gleichstrommotor ausgebildeter Stellmotor angebracht, dessen Antriebswelle zwischen zwei Anschlägen verdrehbar ist. In der Funktionsstellung des Ventils greifen Kupplungselemente der Antriebswelle und des Kurbeltriebs ineinander, so daß die Drehbewegung des Antriebsmotors auf den Kurbeltrieb und damit auf den Schieber übertragen wird.

Der Erfindung liegt die Aufgabe zugrunde, den Stellantrieb für das Ventil zu vereinfachen und die beweglichen Massen des Revolverkopfes zu verringern.

Diese Aufgabe wird durch die Erfindung gemäß Anspruch 1 gelöst. Dabei sind die Schultern des Schiebers als tellerartige Scheiben ausgebildet, deren Abstand zumindest gleich dem Außendurchmesser des Kugellagers ist. Durch die Verwendung des Kugellagers wird die Reibung des Kurbelzapfens gegenüber den Schultern verringert, so daß nahezu kein Verschleiß auftritt, der die Funktionsgenauigkeit der Ventilsteuerung verringern könnte. Der Kurbeltrieb mit dem Wälzlager ist nun im ortsfesten Teil des Revolverkopfes zugeordnet. Damit verringert sich die bewegliche Masse am Revolverkopf, wodurch dessen Taktfrequenz erhöht werden kann.

Da nun der Kurbeltrieb ortsfest angeordnet ist, kann er erheblich schwerer und stabiler ausgebildet werden, wodurch die Funktionsgenauigkeit über einen langen Zeitraum uneingeschränkt erhalten bleibt.

Durch eine vorteilhafte Weiterbildung der Erfindung nach Anspruch 2 ist es möglich, das Spiel zwischen dem Wälzlager und den Schultern so groß zu halten, daß der Kurbelhub größer ist als der Schalthub des Schiebers. Dadurch können die Antriebswelle und eine Lagerachse für das Wälzlager nebeneinander angeordnet werden, was den Herstellungsaufwand für den Kurbeltrieb verringert. Durch die Verwendung eines Schrittmotors entfallen die Anschläge zur Begrenzung der Hubbewegung. Der Schrittmotor wird elektronisch gesteuert. Die Ausgangslage kann mittels einer Lichtschranke eingestellt werden.

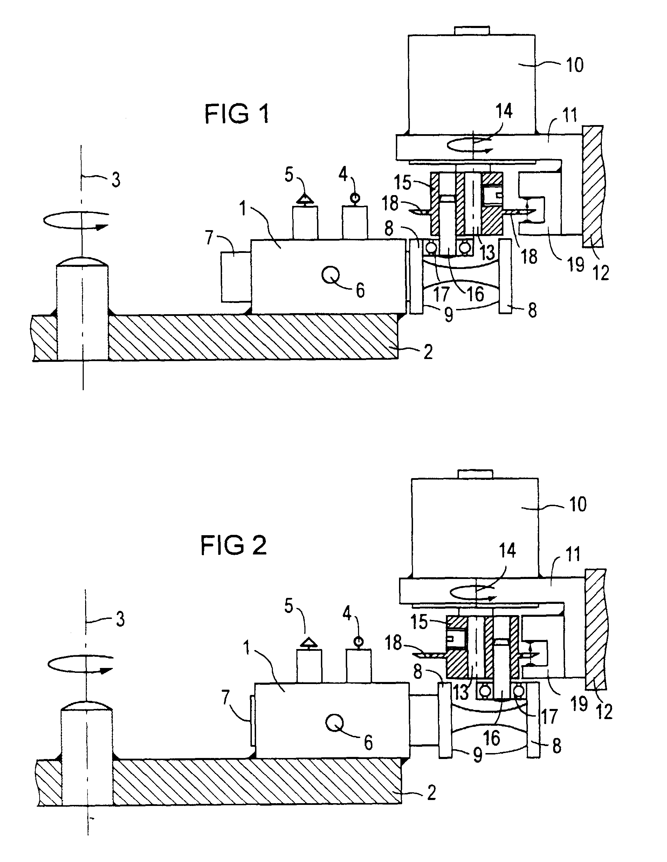

Im folgenden wird die Erfindung anhand eines in der Zeichnung dargestellten Ausführungsbeispieles näher erläutert. Die Figuren 1 und 2 zeigen eine Seitenansicht einer pneumatischen Ventilsteuerung für eine Saugpipette an einem Revolverkopf eines Bestückautomaten zum Aufsetzen von elektronischen Bauelementen auf Leiterplatten, wobei die beiden Figuren unterschiedliche Schaltstellungen der Ventilsteuerung wiedergeben.

Nach den Figuren 1 und 2 ist ein pneumatisches Ventil 1 auf einem Drehteller 2 befestigt, der um eine Drehachse 3 schrittweise rotierbar ist. Das Ventil ist an eine Druckluftleitung 4 und eine Vakuumleitung 5 angeschlossen und über eine Steuerleitung 6 mit einer nicht dargestellten Saugpipette verbunden, die neben dem Ventil 1 auf dem Drehteller befestigt ist. Das Ventil weist einen axial verstellbaren Schieber 7 auf, der die Steuerleitung 6 wahlweise mit der Druckluftleitung 4 oder der Vakuumleitung 5 verbindet. Auf dem Drehteller können z.B. 12 Ventile und Saugpipetten zirkulär verteilt angeordnet sein und nacheinander schrittweise in die in den Figuren gezeigte Stellung verdreht werden.

Der Schieber 7 des radial zur Drehachse 3 stehenden Ventils 1 ragt auf der der Drehachse 3 abgewandten Seite aus dem Ventilgehäuse heraus. Er weist in diesem Bereich zwei scheibenartig umlaufende Querrippen 8 auf, die tangential zum Drehteller gerichtet sind und auf ihren einander zugewandten Seiten quer abstehende Schultern 9 bilden.

Ein Stellmotor 10 ist mittels eines Halters 11 an einem ortsfesten Gehäuseteil 12 des Revolverkopfes befestigt. Eine Antriebswelle 13 des Stellmotors 7 ist um eine Achse 14 schrittweise rotierbar. Auf der Antriebswelle 13 ist ein Kurbeltrieb 15 befestigt, der einen exzentrisch gelagerten, zum Schieber 7 hin vorstehenden Kurbelzapfen 16 aufweist. Dieser ist an seinem freien Ende mit einem als Kugellager ausgebildeten Wälzlager 17 versehen, das zwischen die beiden Schultern 9 ragt und diese abwechselnd mit seiner äußeren Mantelfläche berührt. Der Abstand zwischen Schultern 9 ist größer als der Außendurchmesser des Wälzlagers 16. Durch die tangentiale Ausrichtung der Querrippen 8 kann beim Verdrehen des Drehtellers 2 das Kugellager 17 ungehindert zwischen die beiden Querrippen 8 gelangen.

Das Spiel zwischen den Schultern 9 und dem Wälzlager 16 entspricht z.B. dem Achsabstand zwischen dem Kurbelzapfen 15 und der Antriebswelle 13. Wird der Kurbeltrieb 15 aus der in Figur 1 gezeigten Zwischenstellung die in Figur 2 gezeigte Zwischenstellung um eine halbe Umdrehung geschwenkt, so wird der Schieber 7 erst nach einer viertel Umdrehung vom Wälzlager 17 an seiner äußeren Schulter 9 erfaßt und in eine andere Schaltstellung geschoben, wobei das Wälzlager 17 einen reibungsarmen rollenden Eingriff zwischen dem Kurbelzapfen 16 und den Querrippen 8 ermöglicht.

Der Kurbeltrieb 15 ist außerdem mit einem scheibenartig umlaufenden Steg 18 versehen, der in den Strahlengang einer Lichtschranke 19 ragt. Nutartige Einschnitte im Steg 18 ermöglichen phasenweise den ungehinderten Lichtdurchtritt und die optoelektronische Überwachung der Drehlage des Kurbeltriebes 15.

## Patentansprüche

1. Bestückautomat mit einem Revolverkopf und einer pneumatischen Ventilsteuerung für am Revolverkopf angeordnete Saugpipetten zum Aufsetzen von elektrischen Bauelementen auf eine Leiterplatte, wobei der Revolverkopf mit drehbar gelagerten Ventilen (1) und mit zumindest einer ortsfesten elektrischen Antriebseinrichtung zum Betätigen von Schiebern (7) der Ventile versehen ist, wobei jeweils der Schieber (7) aus einem Gehäuse des Ventils (1) herausragt und in diesem Abschnitt mit quer zur Verschieberichtung abstehenden Schultern (9) versehen ist, wobei das Ventil (1) in eine Betätigungsstellung verfahrbar ist, in der es in den Wirkungsbereich der Antriebseinrichtung gelangt, wobei die Antriebseinrichtung einen Stellmotor (10) aufweist, wobei zwischen dem Stellmotor (10) und dem Ventil (1) ein Kurbeltrieb (15) vorgesehen ist, der mit einem Kurbelzapfen (16) zwischen die Schultern (9) des Schiebers (7) eingreift,
**dadurch gekennzeichnet,**
daß die Antriebseinrichtung mit dem Kurbeltrieb (15) ortsfest angeordnet ist, und daß der Kurbelzapfen (16) exzentrisch gelagert und mit einem Wälzlager (17) versehen ist, das zwischen die beiden Schultern (9) ragt.

2. Bestückautomat nach Anspruch 1,
**dadurch gekennzeichnet,**
daß der Stellmotor (10) als Schrittmotor ausgebildet ist, daß der Kurbeltrieb (15) an einer Antriebswelle (13) des Schrittmotors (10) befestigt ist und daß der freie Abstand zwischen den Schultern (9) größer ist, als der Außendurchmesser des Wälzlagers (17).

## Claims

1. Automatic assembly machine having a turret head and a pneumatic valve control for suction pipettes, arranged on the turret head, for mounting electrical components in place on a printed circuit board, the turret head being provided with rotatably mounted valves (1) and with at least one fixed electrical drive device for the actuation of spools (7) of the valves, in each case the spool (7) projecting from a housing of the valve (1) and being provided in this section with shoulders (9) protruding transversely to the displacing direction, the valve (1) being shiftable into an actuating position in which it passes into the effective region of the drive device, the drive device having a servomotor (10), a crank mechanism (15) being provided between the servomotor (10) and the valve (1), which crank mechanism (15), with a crank pin (16), engages between the shoulders (9) of the spool (7), characterized in that the drive device is arranged fixedly with the crank mechanism (15), and in that the crank pin (16) is eccentrically mounted and is provided with a rolling-contact bearing (17), which projects between the two shoulders (9).

2. Automatic assembly machine according to Claim 1, characterized in that the servomotor (10) is designed as a stepping motor, in that the crank mechanism (15) is fastened to a drive shaft (13) of the stepping motor (10), and in that the free distance between the shoulders (9) is greater than the outside diameter of the rolling-contact bearing (17).

## Revendications

1. Machine automatique de pose de composants, comportant une tête revolver et une commande pneumatique de valves pour des pipettes d'aspiration montées sur la tête revolver, pour déposer des composants électriques sur une plaquette à circuit imprimé, la tête revolver étant munie de valves (1) montées tournantes et d'au moins un dispositif d'entraînement électrique à poste fixe pour actionner des obturateurs (7) des valves, chaque obturateur (7) faisant saillie d'un boîtier de valve (1) et étant muni sur ce tronçon d'épaulements (9) en saillie transversalement par rapport à la direction de coulissement, la valve (1) pouvant être déplacée à une position d'actionnement en laquelle elle parvient dans la zone active du dispositif d'entraînement, le dispositif d'entraînement comportant un servomoteur (10), une transmission (15) à manivelle, qui engrène par un tourillon (16) de manivelle entre les épaulements (9) de l'obturateur (7) étant prévu entre le servomoteur (10) et la valve (1), caractérisée en ce que le dispositif d'entraînement comportant la transmission (15) à manivelle est monté à poste fixe et en ce que le tourillon (16) de manivelle est monté excentriquement et muni d'un palier à roulement (17) qui fait saillie entre les deux épaulements.

2. Machine automatique pour poser des composants suivant la revendication 1, caractérisée en ce que le servomoteur (10) est réalisé en moteur pas à pas, en ce que la transmission (15) à manivelle est fixée à un arbre (13) d'entraînement du moteur (10) pas à pas et en ce que la distance libre entre les épaulements (9) est plus grande que le diamètre extérieur du palier à roulement (17).
